# EUROPEAN PATENT SPECIFICATION

(11) **EP 2 738 286 B1**
(45) Date of publication and mention of the grant of the patent: **28.10.2015**
(21) Application number: 12805271.9
(22) Date of filing: 28.06.2012
(51) Int. Cl.: C23C 16/26, C23C 16/38, G05B 19/418

(54) **PRODUCT HAVING TRACEABILITY DISPLAYED THEREON AND METHOD FOR DISPLAYING TRACEABILITY OF PRODUCT**
PRODUKT MIT DARAUF ANGEZEIGTER RÜCKVERFOLGBARKEIT UND VERFAHREN ZUR ANZEIGE DER RÜCKVERFOLGBARKEIT EINES PRODUKTS
PRODUIT PRÉSENTANT UNE TRAÇABILITÉ AFFICHÉE SUR CELUI-LUI ET PROCÉDÉ D'AFFICHAGE DE LA TRAÇABILITÉ DU PRODUIT

(30) Priority: 30.06.2011 JP 2011145392; 30.06.2011 JP 2011146901; 18.05.2012 JP 2012114086
(43) Date of publication of application: 04.06.2014
(73) Proprietor: Momentive Performance Materials Japan LLC, Tokyo 107-6112 (JP)
(72) Inventor: MORIKAWA Yuji, Sayo-gun Hyogo 679-5641 (JP); MATSUI Yoshihiko, Sayo-gun Hyogo 679-5641 (JP); HASEGAWA Tomoo, Sayo-gun Hyogo 679-5641 (JP)
(74) Representative: Potter Clarkson LLP
(86) International application number: PCT/JP2012/066562
(87) International publication number: WO 2013/002334

(56) References cited:
- JP-A- 9 059 766
- JP-A- 11 260 675
- JP-A- 62 169 448
- JP-A- 2003 267 378
- JP-A- 2005 142 496
- JP-A- 2006 145 509
- JP-A- 2009 231 246
- US-A- 5 882 730

## Description

### Field of Art

The present invention relates to a product having traceability displayed thereon and a method for displaying traceability of a product, and more specifically to a technique for displaying traceability on a PBN product or PG-coated product.

### Background Art

Traceability means the ability to trace a distribution history of an object product, which has been widely used in a field of foods as index of food safety. Its necessity or importance has been recognized in recent years in industrial products as well.

PG has excellent physical properties such as thermal conductivity, thermal resistance, chemical stability and impact resistance, and many PG-coated products have been manufactured and used, which comprises a body made of electrical insulating material such as PBN and formed into a predetermined container shape and a PG coat on its surface.

By way of example, in the art of electron beam vapor deposition (including ion-plating) wherein electron beams are used as source of evaporation for vapor deposition of a metallic thin film on a substrate of an electronic component, a water-cooled melting pot (hearth) made of copper is filled with evaporant for irradiation of electron beams. The recent main current is that a hearth liner fitted in the hearth is filled with evaporant for irradiation of electron beams. One known hearth liner comprises a PBN (pyrolytic boron nitride) body and an overcoat of conductive material such as PG formed on its surface (Patent Document 1).

If a hearth liner should be made only of PBN having a layer structure, when this is filled with aluminum as evaporant to irradiate electron beams, the molten aluminum will creep up to a top of a container wall of the hearth liner due to the surface tension so that it will percolate into the PBN layer exposed in cross-section to the top of the container wall. When this molten aluminum is solidified after being cooled, it could possibly expand the PBN layer to delaminate and damage the hearth liner. One solution for preventing this problem is to coat the surface with PG.

Traceability is also important for such PG-coated products. When a serial number, for example, indicating the date of manufacture, the factory of manufacture and the inspection results, etc. is given to each PG-coated product and administrated under computer control, this can be used for quality control, complaint handling, return management, durable period management, etc.

On the contrary, PBN has excellent physical properties such as insulation quality, thermal resistance, chemical stability and impact resistance, which has been widely used for various melting pots used for manufacturing semiconductor wafers and hearth liners (melting pots) for metal vapor deposition. PBN-coated products comprising a body made of electrical insulating material such as PBN and formed into a predetermined shape and a PBN coat formed on its surface have also been frequently used for heaters heating wafers and/or substrates and for electrostatic chucks supporting them.

By way of example, Patent Document 2 discloses an electrostatic chuck with a heater mechanism, which is manufactured by obtaining a graphite substrate machined into substantially a cup-like shape or substantially a hat-like shape, forming a PBN insulating layer on both surfaces of the graphite substrate by a CVD (chemical vapor deposition) method, forming a PG (pyrolytic graphite) layer on its top surface by a CVD method, removing a part of the PG coat so as to form chuck electrodes of a predetermined pattern, forming, in the same way, PG heater layers on the back surface of the top and at predetermined areas on the outside of the side wall, and then forming a PBN overcoat by a CVD method to cover the entire body.

Traceability is also important for such PBN-coated products. When a serial number, for example, indicating the date of manufacture, the factory of manufacture and the inspection results, etc. is given to each PG-coated product and administrated under computer control, this can be used for quality control, complaint handling, return management, durable period management, etc.

The conventional method of giving a traceability indicator to the PG-coated product or the PBN-coated product is to hand-write or engrave its serial number on the bottom of the PG- or PBN-coated product after it has be manufactured as a final product.

However, the serial number indicated by hand-writing or engraving the PG- or PBN-coated product itself should become gradually unclear and illegible, because the PG- or PBN-coated product is repeatedly used and washed in severe conditions.

For example, when plural PG-coated products are used in various processes such as the above-described electron beam vapor deposition, it is often the case that the products have different product lots. In addition, a specific one of the PG-coated products is not always used at the same location in a particular process or in a particular device. For these reasons, If the serial number should become illegible at the time when the PG-coated product is picked up after being used, the traceability of the said PG-coated product is completely lost.

This can also be said to the PBN-coated product. When a PBN-coated product such as heater or electrostatic chuck is used in a wafer manufacturing process, it is often the case that the products have different product lots. In addition, a specific one of the PBN-coated products is not always used at the same location in a particular process or in a particular device. For these reasons, If the serial number should become illegible at the time when the PBN-coated product is picked up after being used, the traceability of the said PBN-coated product is completely lost.

Further, engraving the serial number would damage the PG- or PBN-coated product, resulting in a decrease of functions and/or durability intrinsic to the said product. Accordingly, this is not a preferred method.
Patent Document 1: JP H09-059766 A
Patent Document 2: JP 2005-142496 A

### Summary of Invention

### Problems to be Solved by the Invention

An object of the present invention is to provide a novel, useful method of indicating traceability, which may be carried out in place of the conventional method of handwriting or engraving.

More specifically, the object of the present invention is to provide a PG-coated product having a traceability indicator that will keep visibility even if subjected to repeated use and wash, and to provide a traceability display method for indicating traceability of a PG-coated product with good and long-lasting visibility

Another object of the present invention is to provide a PBN-coated product having a traceability indicator that will keep visibility even if subjected to repeated use and wash, and to provide a traceability display method for indicating traceability of a PBN-coated product with good and long-lasting visibility

### Means for Solving the Problems

In the course of manufacturing various PG-coated products, the inventors have found the fact that a PG coat, which has been recognized to be opaque, may become transparent by controlling its coating thickness. Based on this finding, they have made repeated studies and experiments to finally reach the present invention for solving the above-described problems.

The present invention according to claim 1 is a PG-coated product comprising a body and a PG coat formed on a surface thereof, characterized by a traceability indicator made of graphite at any place on the body surface, said traceability indicator being visible from the outside through the PG coat having a thickness of 100 *µ*m or less. By setting the thickness of the PG coat to 100 *µ*m or less, it is possible to provide transparency sufficient for reading the traceability indicator on the body surface.

In accordance with this invention, the traceability indicator is provided between the body and the PG coat during manufacturing of the PG-coated product, so that the traceability indicator will not be lost even if subjected to repeated use and wash. In addition, the body and the PG coat will not be damaged, which makes it possible to retain functions and durability intrinsic to the PG-coated product.

The present invention according to claim 2 is a method for manufacturing a PG-coated product with a traceability indicator, characterized by manufacturing a body, providing a traceability indicator at any place of a surface of the body with graphite, and coating the body surface, including the traceability indicator, with a PG coat having a thickness of 100 *µ*m or less. By setting the thickness of the PG coat to 100 *µ*m or less, it is possible to provide transparency sufficient for reading the traceability indicator on the body surface.

The present invention according to claim 3 is a PBN-coated product with a traceability indicator, characterized in that the traceability indicator made of graphite is provided at any place on a PBN surface of a body, at least of a surface thereof being made of PBN, and a PBN layer overcoats the PBN body surface including the traceability indicator, said PBN overcoat having a thickness of 700 *µ*m or less, said traceability indicator being visible from the outside through the PBN overcoat. By setting the thickness of the PBN overcoat to 700 *µ*m or less, it is possible to provide transparency sufficient for reading the indication of traceability on the PBN body surface.

In accordance with the invention of claim 3, the traceability indicator provided at a predetermined place on the PBN body surface of the PBN-overcoated product is coated with the PBN overcoat formed on the PBN surface, so that the traceability indicator will not be lost even if subjected to repeated use and wash.

In addition, because graphite will not adversely affect the physical properties of PBN, the functions and durability intrinsic to the PBN product will not be damaged by the traceability indicator interposed between the PBN body surface and the PBN overcoat.

The present invention according to claim 4 is a method for displaying traceability to a PBN product, characterized by manufacturing a body wherein at least a surface thereof is made of PBN, providing an traceability indicator of graphite at any place of a PBN surface of the body, and overcoating the surface, including the traceability indicator, with a PBN overcoat, said PBN overcoat having a thickness of 700 *µ*m or less so that the traceability indicator is visible from the outside through the PBN overcoat. By setting the thickness of the PBN overcoat to 700 *µ*m or less, it is possible to provide transparency sufficient for reading the traceability indicator on the PBN body surface.

### Brief Description of Drawings

Fig.1 is a flow diagram showing the process for manufacturing a PG-coated product with a traceability indicator according to the present invention;
Fig.2 is a PG-coated PBN hearth liner (a PG-coated product) according to one embodiment of the present invention;
Fig.3 is a photograph showing visibility of a product serial number (a traceability indicator) of a PG-coated PBN hearth liner (a PG-coated product) that is manufactured by setting the thickness of a PG coat to 10 *µ*m in Example 1 of the present invention;
Fig.4 is a photograph showing visibility of a product serial number (a traceability indicator) of a PG-coated PBN hearth liner (a PG-coated product) that is manufactured by setting the thickness of a PG coat to 20 *µ*m in Example 1 of the present invention;
Fig.5 is a photograph showing visibility of a product serial number (a traceability indicator) of a PG-coated PBN hearth liner (a PG-coated product) that is manufactured by setting the thickness of a PG coat to 30 *µ*m in Example 1 of the present invention;
Fig.6 is a photograph showing visibility of a product serial number (a traceability indicator) of a PG-coated PBN hearth liner (a PG-coated product) that is manufactured by setting the thickness of a PG coat to 80 *µ*m in Example 1 of the present invention;
Fig.7 is a photograph showing visibility of a product serial number (a traceability indicator) of a PG-coated PBN hearth liner (a PG-coated product) that is manufactured by setting the thickness of a PG coat to 100 *µ*m in Example 1 of the present invention;
Fig.8 is a flow diagram showing the process for manufacturing a PBN-overcoated product with a traceability indicator according to the present invention;
Fig.9 is a cross-section showing an example of PBN-overcoated product with a traceability indicator according to one embodiment of the present invention;
Fig.10 is a cross-section showing another example of PBN-overcoated product with a traceability indicator according to one embodiment of the present invention;
Fig.11 is a photograph showing visibility of a product serial number (a traceability indicator) of a PBN-overcoated product that is manufactured by setting the thickness of a PBN overcoat to 300 *µ*m in Example 2 of the present invention;
Fig.12 is a photograph showing visibility of a product serial number (a traceability indicator) of a PBN-overcoated product that is manufactured by setting the thickness of a PBN overcoat to 500 *µ*m in Example 2 of the present invention;
Fig.13 is a photograph showing visibility of a product serial number (a traceability indicator) of a PBN-overcoated product that is manufactured by setting the thickness of a PBN overcoat to 700 *µ*m in Example 2 of the present invention;
Fig.14 is a photograph showing visibility of a product serial number (a traceability indicator) of a PBN-overcoated product that is manufactured by setting the thickness of a PBN overcoat to 900 *µ*m in Example 2 of the present invention; and

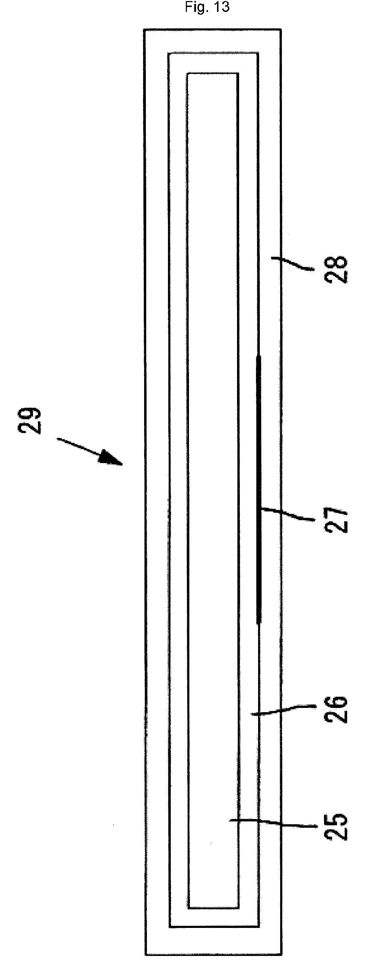

Fig.15 is a cross-section showing still another example of PBN-overcoated product with a traceability indicator according to one embodiment of the present invention.

### Embodiments for Practicing the Invention

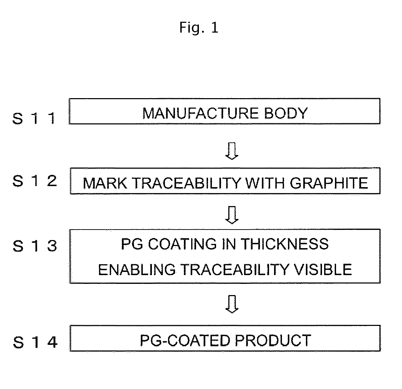

Fig.1 is a flow diagram showing the process for manufacturing a PG-coated product with a traceability indicator according to the present invention.

At first, a body of the PG-coated product is manufactured (S11). For example, when a PG-coated PBN hearth liner with a traceability indicator is to be manufactured, a body of the PBN hearth liner is manufactured by a CVD (chemical vapor deposition) method. The body material is not specifically limited but preferably one that will not deteriorate by graphite, because a traceability indicator is given thereto with graphite and then a PG coat is formed thereon. Such preferable material includes PBN and SiC, for example.

Then, the body manufactured at S11 is removed from a mandrel, and a product serial number representing traceability of the product is marked at an unnoticeable place on its surface, for example on its bottom (S12). This indicator is made of graphite, preferably purified graphite, in order not to affect the physical properties of a PG coat to be coated at the next step S13.

Then, the entire surface (preferably both top and bottom surfaces) on which the traceability indicator has been provided is coated with PG. At this time, by controlling the film deposition conditions so as to form a PG coat of 100 *µ*m or less in thickness, it is possible to provide transparency sufficient for reading the traceability indicator provided on the body surface.

Consequently, the PG-coated product thus manufactured (S14) has the traceability indicator provided between the body surface and the PG coat, which is visible from the outside through the PG coat, so that the traceability indicator will not be lost even if subjected to repeated use and wash over a long period of time. The traceability indicator is made of graphite material, which will not at all affect the physical properties and the functions intrinsic to the body made of PBN, for example, and also to the PG coat.

The present invention will be described in detail in reference to an embodiment thereof.

### Example 1

A PBN hearth liner body 11 was manufactured by a thermal CVD method in such a way that PBN is vapor-deposited onto a mandrel of a predetermined shape. More specifically, a mandrel for a hearth liner was installed in an electric furnace, and a vacuum pump was connected thereto to reduce a pressure in the furnace to 1 Torr or below, into which boron trichloride (BCl₃) and ammonia gas (NH₃) were introduced at flow rates of 1.0 liter per minute and 3.0 liters per minute, respectively, together with a carrier gas, to produce reaction at 1900°C for 20 hours. The PBN hearth liner body 11 thus obtained had a cup-like shape having a wall thickness of 1mm, an internal diameter of 70mm and an external diameter of 72mm.

This PBN hearth liner body 11 was removed from the mandrel, and its product serial number 12 indicating traceability was marked on the bottom with a pen made of purified graphite. The product serial number 12 comprised a digit sequence "12345" common to all samples at an upper row and another digit sequence "01 "-"05" indicating thickness (see below) of the PG coat 13 at a lower row, which was marked by using a drawing template with digit-shaped holes.

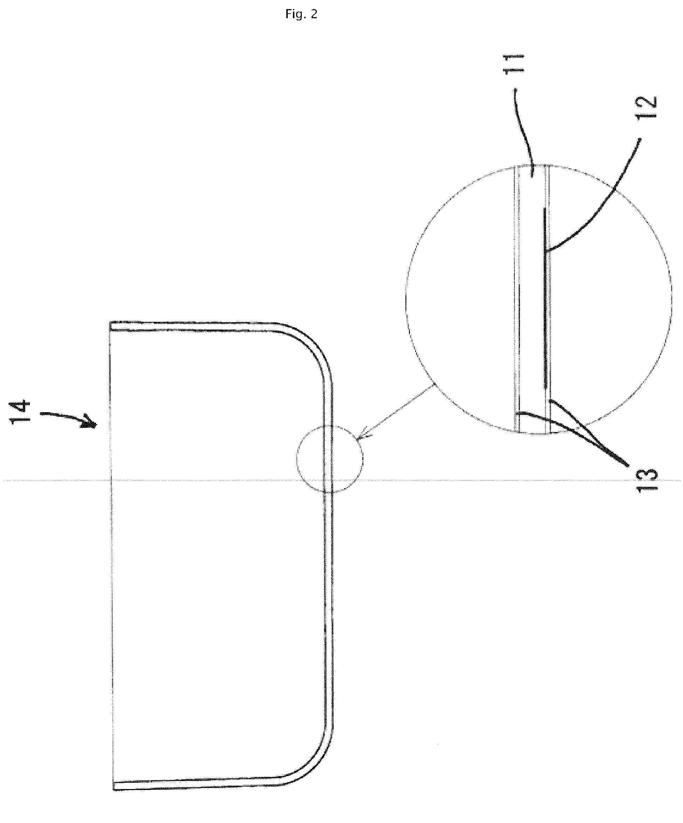

Then, PG was vapor-deposited on the entire surface (both top and bottom surfaces) of the PBN hearth liner body 11 to which the product serial number 12 had been marked, by the thermal CVD method similar to the above-mentioned to form a conductive layer 13, so that a PG-coated PBN hearth liner 14 (a PG-coated product) such as shown in Fig.2 was manufactured. In this example, the deposition conditions were controlled such that the PG coat 13 have different five thickness, say 10 *µ*m, 20 *µ*m, 30 *µ*m, 80 *µ*m and 100 *µ*m, and the digit sequence "01"-"05" were in advance marked at the lower row of the product serial number, as described before, for the purpose of identification.

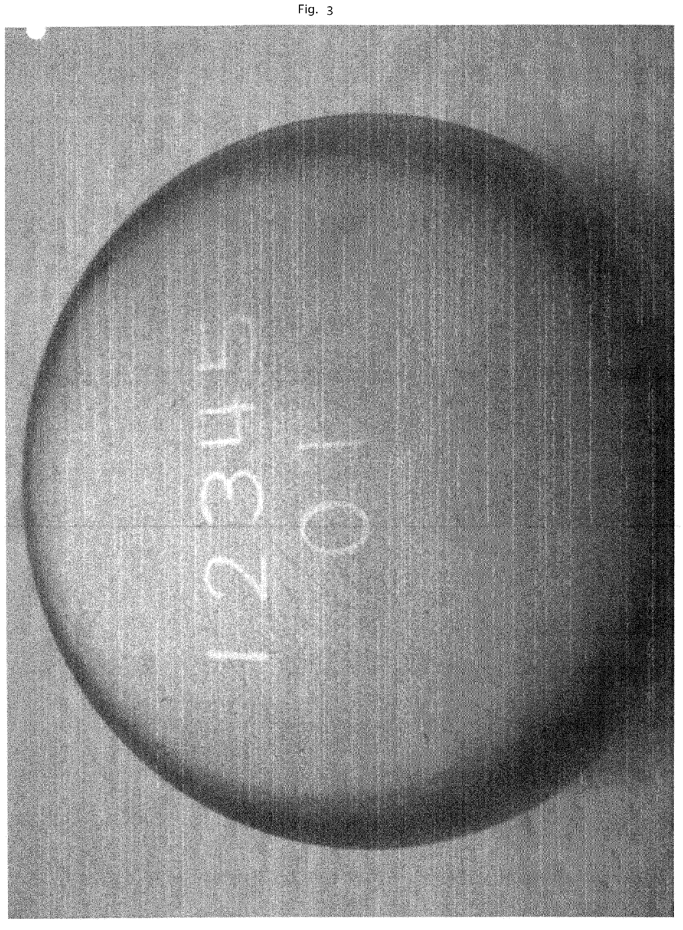

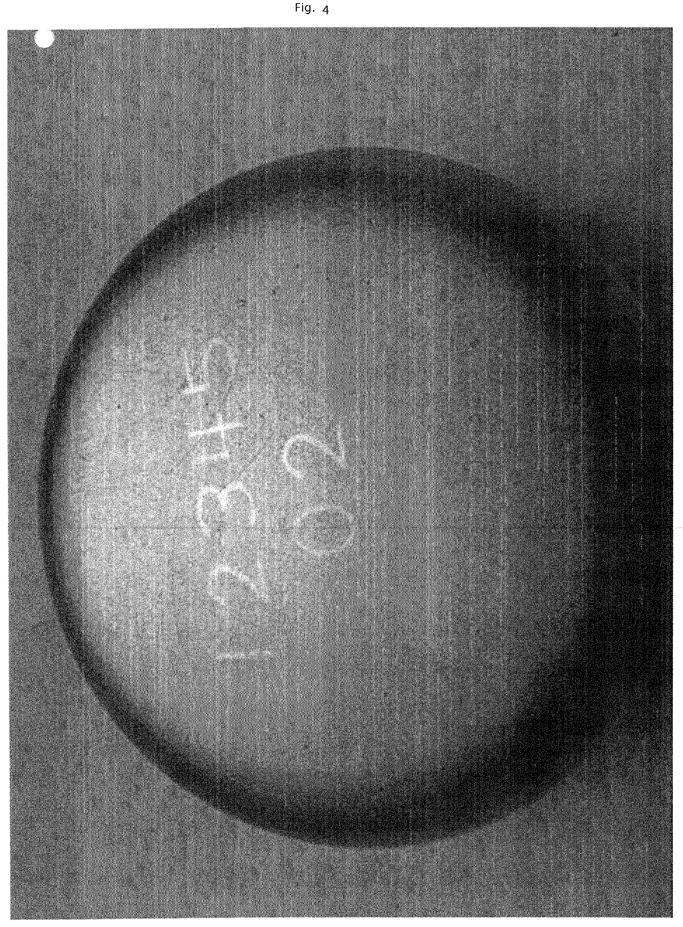

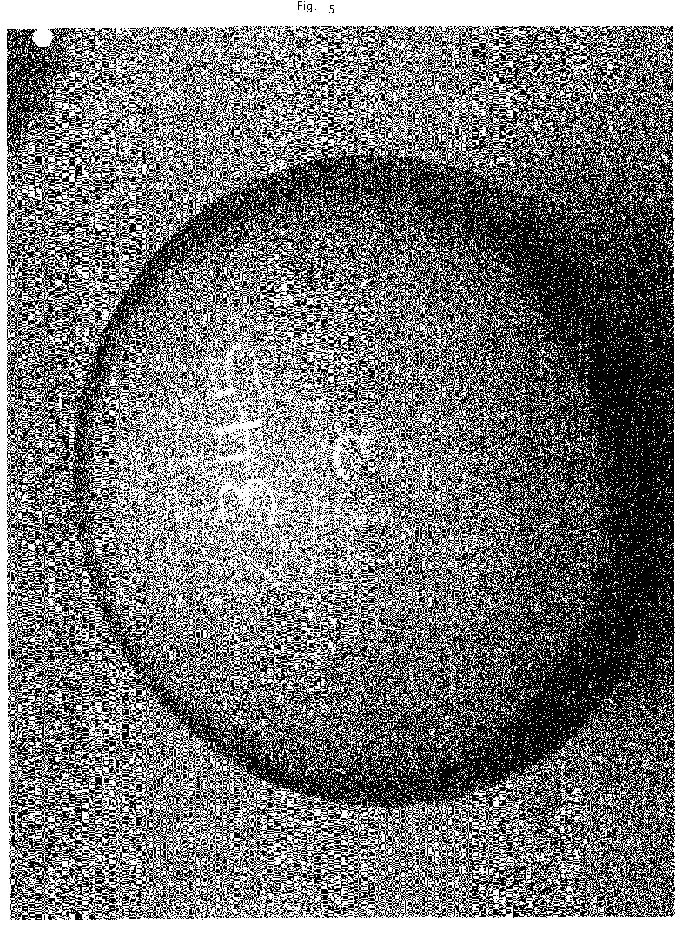

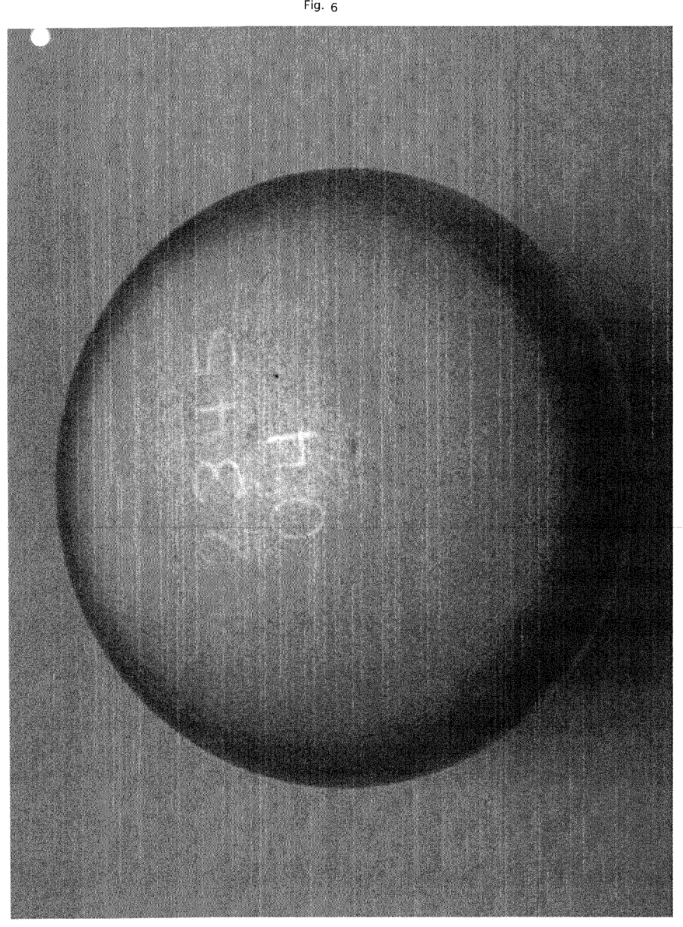

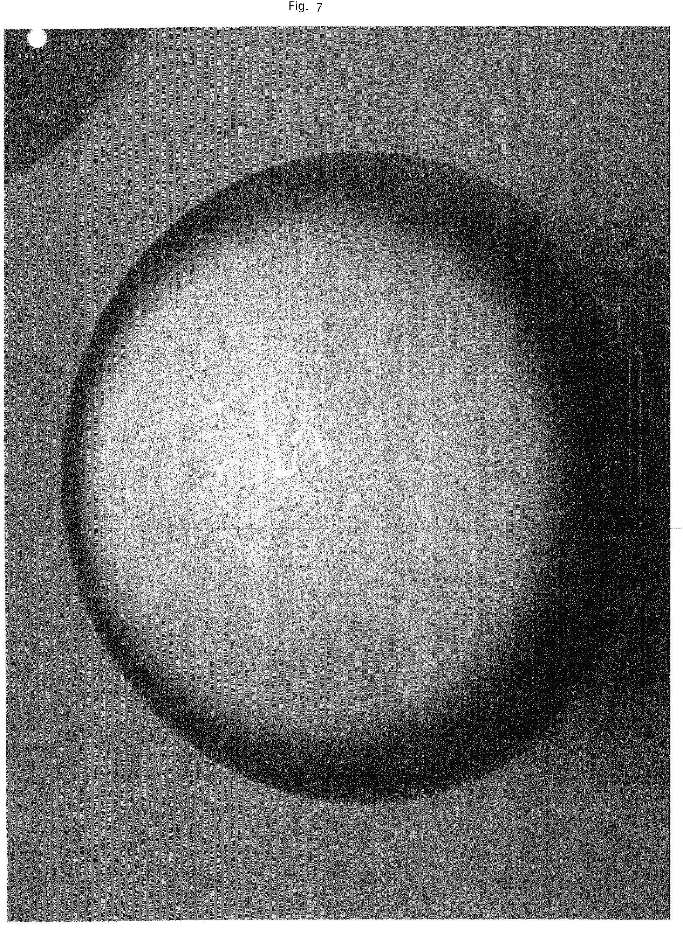

With respect to these five PG-coated PBN hearth liners 14 thus manufactured, whether the product serial number 12 was clearly visible or not was observed by the naked eye from the outside. The results are shown in the following Table 1 and in Fig.3 to Fig.7.

**Table 1**

| PG Thickness (*µ*m) | Visibility of Product Serial Number |
|---|---|
| 10 | clearly visible |
| 20 | as above |
| 30 | as above |
| 80 | not so clear but sufficiently visible |
| 100 | almost invisible |

These results will show that, though a PG coat has been recognized to be opaque, by controlling the thickness to 100 *µ*m or less, it is possible to provide transparency sufficient for reading the product serial number marked on the body surface, which proves that this is a suitable way for indication of traceability. The PG coating thickness of 100 *µ*m showed degraded visibility so that the product serial number was almost invisible, and the upper limit of PG coating thickness should therefore be determined to be 100 *µ*m. A more preferable upper limit is 80 *µ*m.

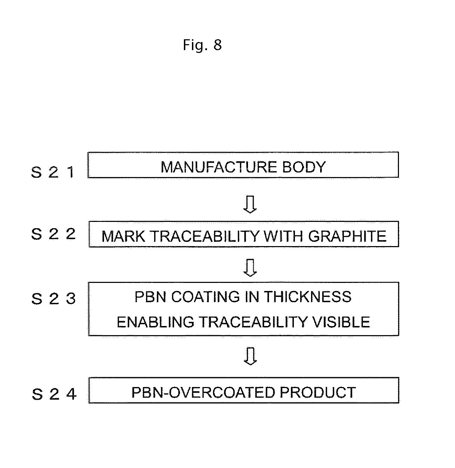

Fig.8 is a flow diagram showing the process for manufacturing a PBN-overcoated product with a traceability indicator according to the present invention.

At first, a PBN product is manufactured (S21). The PBN product has at least a surface made in main of PBN, which may be made of pure PBN material or a PBN-coated product comprising, for example, a substrate made of PG, for example, and a PBN coat formed on a surface thereof by using a CVD method, for example.

Then, the body manufactured at S1 is removed from a mandrel, and a product serial number representing traceability of the product is marked at an unnoticeable place on its surface, for example on its bottom (S22). This indication is made of graphite, preferably purified graphite, in order not to affect the physical properties of the PBN surface of the product and a PBN overcoat to be coated at the next step S3.

Then, the surface of the PBN including a traceability indicator (preferably the entire surface thereof) is coated with PBN by using a CVD method, for example, to form a PBN overcoat (S23). At this time, by controlling the film deposition conditions so as to form a PBN overcoat of 700 *µ*m or less in thickness, it is possible to provide transparency sufficient for reading the traceability indicator provided on the PBN surface.

Consequently, the PBN-overcoated product thus manufactured (S24) has the traceability indicator provided between the PBN surface of the body and the PBN overcoat, which is visible from the outside through the PBN overcoat, so that the traceability indicator will not be lost even if subjected to repeated use and wash over a long period of time. The traceability indicator is made of graphite material, which will not at all affect the physical properties and functions intrinsic to the PBN body surface and also to the PG coat.

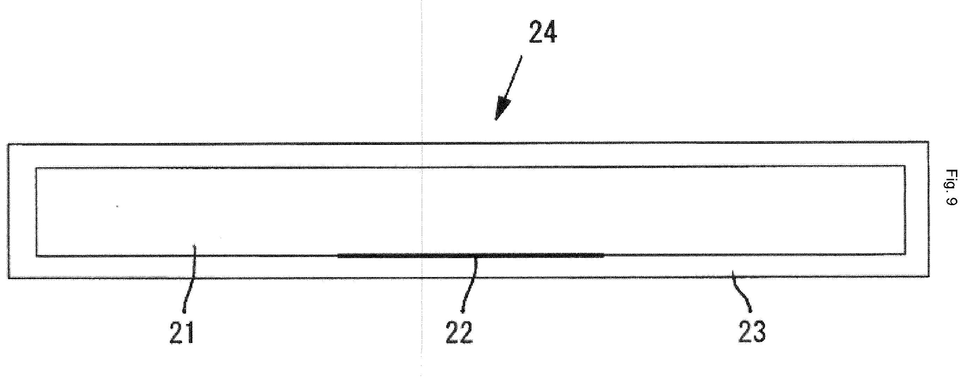

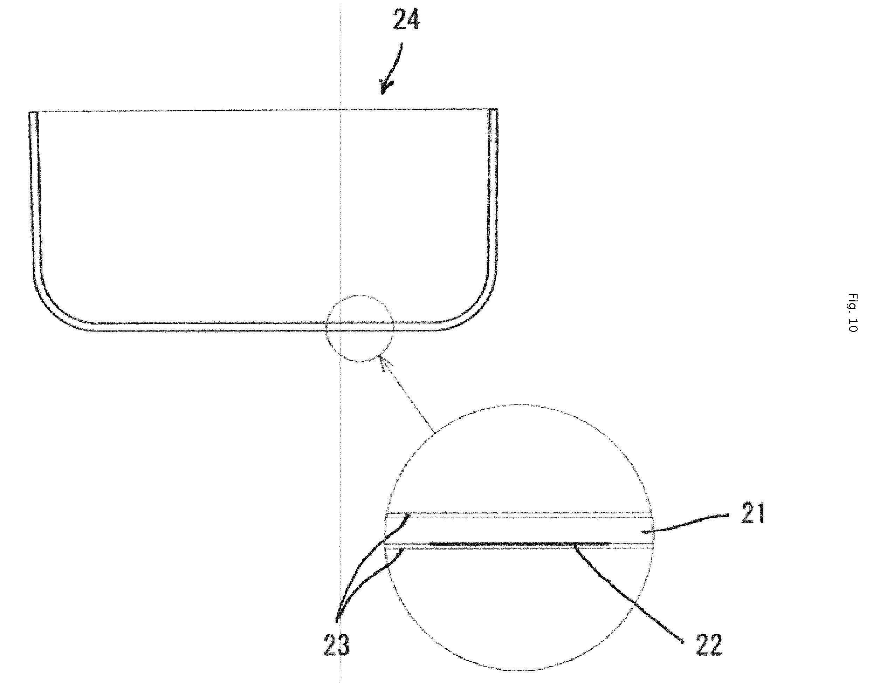

Fig.9 and Fig.10 illustrate by example PBN-overcoated product with a traceability indicator according to the present invention. Fig.9 shows a plate-shaped PBN-overcoated product 24, and Fig.10 shows a PBN-overcoated product 24 that is formed as a cup-shaped hearth liner. A method for manufacturing the PBN-overcoated product 24 shown in Fig.9 will be described below, and it is apparent that the PBN-overcoated product 24 shown in Fig.10 may also be manufactured in the same manner.

A PBN body 21 is manufactured by a thermal CVD method in such a way that PBN is vapor-deposited onto a mandrel of a predetermined shape. More specifically, a mandrel for a hearth liner is installed in an electric furnace, and a vacuum pump was connected thereto to reduce a pressure in the furnace to 1 Torr or below, into which boron trichloride (BCl₃) and ammonia gas (NH₃) are introduced at flow rates of 1.0 liter per minute and 3.0 liters per minute, respectively, together with a carrier gas, to produce reaction at 1900°C for 20 hours.

This PBN body 21 is removed from the mandrel, and its product serial number 22 indicating traceability is marked on the bottom with a pen made of purified graphite. Preferably, the product serial number 22 is marked by using a drawing template with digit-shaped holes.

Then, PBN is vapor-deposited on the entire surface (both top and bottom surfaces) of the PBN hearth liner body 21 to which the product serial number 22 has been marked, by the thermal CVD method similar to the above-mentioned one to form a PBN overcoat 23, so that the PBN-overcoated product 24 such as shown in Fig.9 was manufactured.

The PBN-overcoated product 24 has the product serial number 22 marked on the surface of the PBN body 21, which is visible from the outside through the PBN overcoat 23 and may be sufficiently read even after repeated use and wash to keep the efficiency as the traceability indicator. From this point of view, the thickness of the PBN overcoat 23 is preferably 700 *µ*m or less, and more preferably 500 *µ*m or less. The product serial number 22 made of graphite will not affect the physical properties and functions of the PBN body 1 and the PBN overcoat 23.

The present invention will be described in detail in reference to an embodiment thereof.

### Example 2

A PBN-overcoated product was manufactured by a thermal CVD method in such a way that PBN is vapor-deposited onto a mandrel of a predetermined shape. More specifically, a mandrel for a hearth liner was installed in an electric furnace, and a vacuum pump was connected thereto to reduce a pressure in the furnace to 1 Torr or below, into which boron trichloride (BCl₃) and ammonia gas (NH₃) were introduced at flow rate of 1.0 liter per minute and 3.0 liters per minute, respectively, together with a carrier gas, to produce reaction at 1900°C for 20 hours. The PBN hearth liner body 21 thus obtained had a cup-like shape having a wall thickness of 1mm, an internal diameter of 70mm and an external diameter of 72mm.

This PBN hearth liner body 21 was removed from the mandrel, and its product serial number 22 indicating traceability was marked on the bottom with a pen made of purified graphite. The product serial number 22 comprised a digit sequence "23456" common to all samples at an upper row and another digit sequence "01"-"04" indicating thickness (see below) of the PBN overcoat 3 at a lower row, which was marked by using a drawing template with digit-shaped holes.

Then, PBN was vapor-deposited on the entire surface (both top and bottom surfaces) of the PBN hearth liner body 11 to which the product serial number 22 had been marked, by the thermal CVD method similar to the above-mentioned to form a PBN overcoat 23, resulting in a PBN-overcoated PBN hearth liner 24 (a PBN-overcoated product) such as shown in Fig.10. In this example, the deposition conditions were controlled such that the PBN overcoat 23 have different four thickness, say 300 *µ*m, 500 *µ*m, 700 *µ*m and 900 *µ*m, and the digit sequence "01"-"04" were in advance marked at the lower row of the product serial number, as described before, for the purpose of identification.

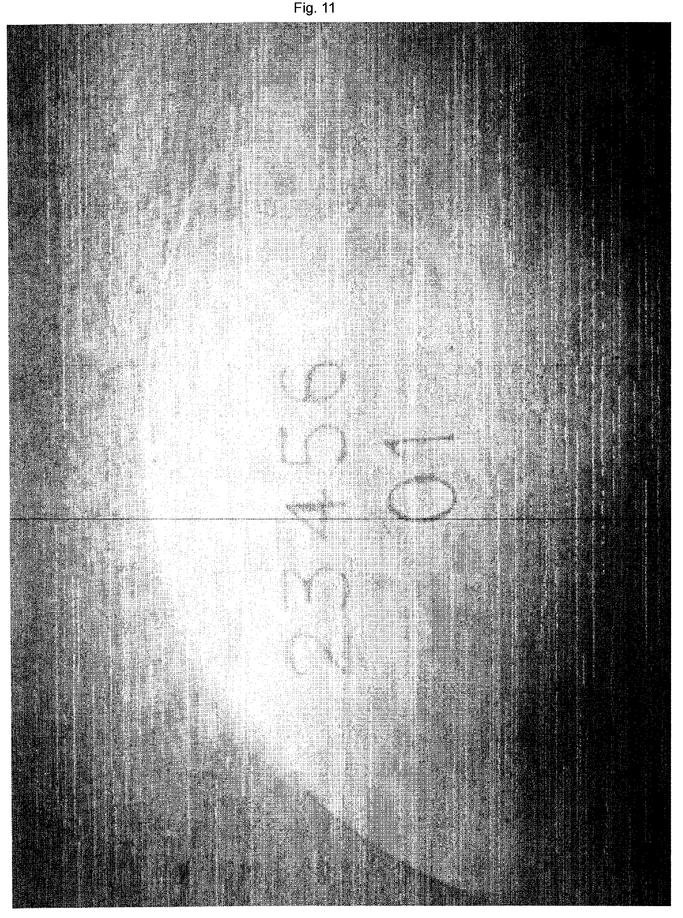

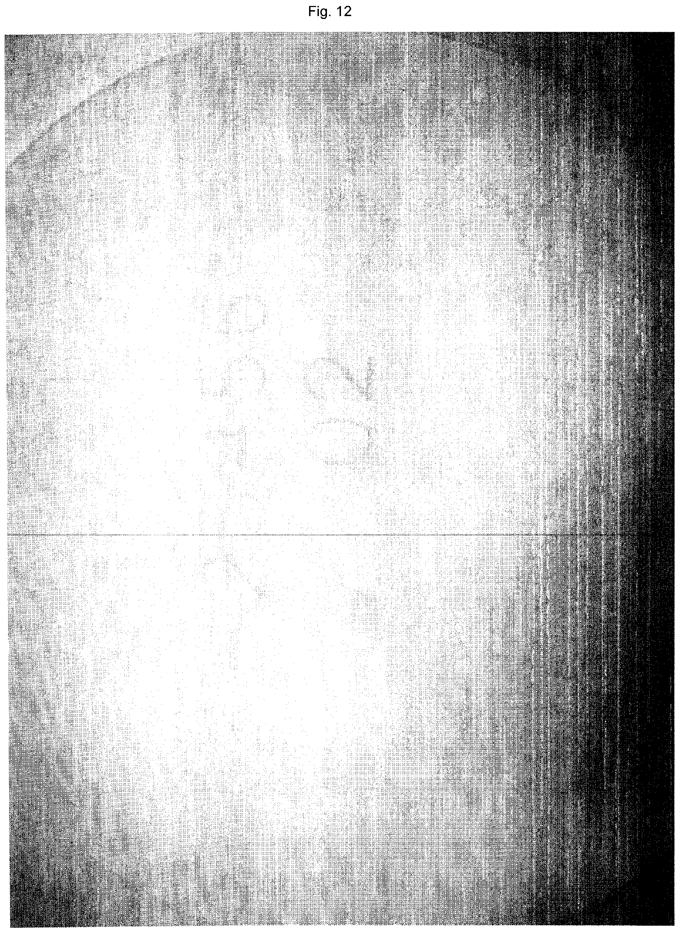

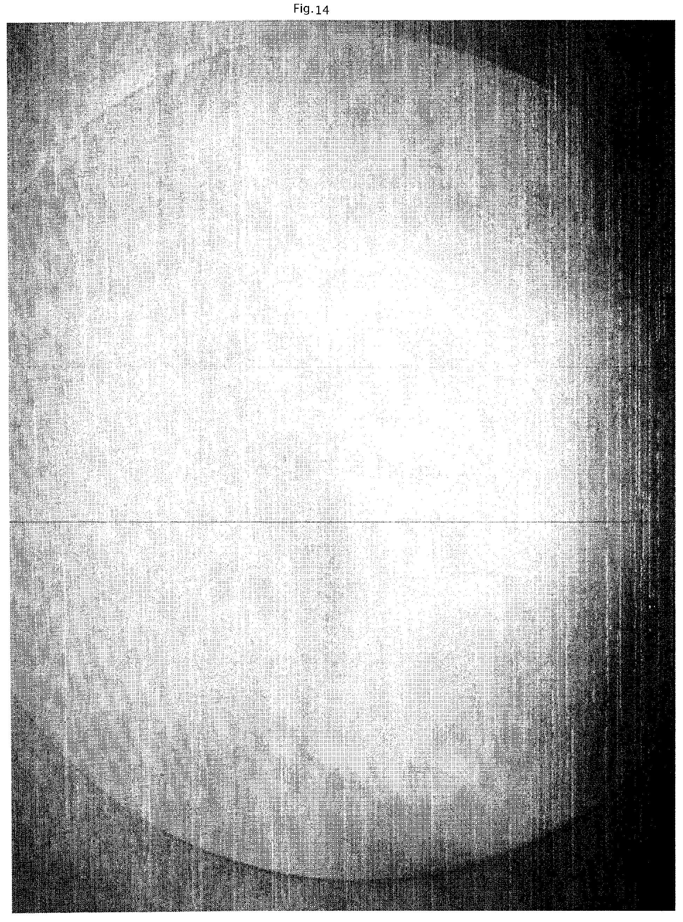

With respect to these four PBN-overcoated PBN hearth liners 24 thus manufactured, whether the product serial number 22 was clearly visible or not was observed by the naked eye from the outside. The results are shown in the following Table 2 and in Fig.11 to Fig.14.

**Table 2**

| PBN Thickness (*µ*m) | Visibility of Product Serial Number |
|---|---|
| 300 | clearly visible |
| 500 | as above |
| 700 | not so clear but sufficiently visible |
| 900 | barely visible but digits not distinguishable |

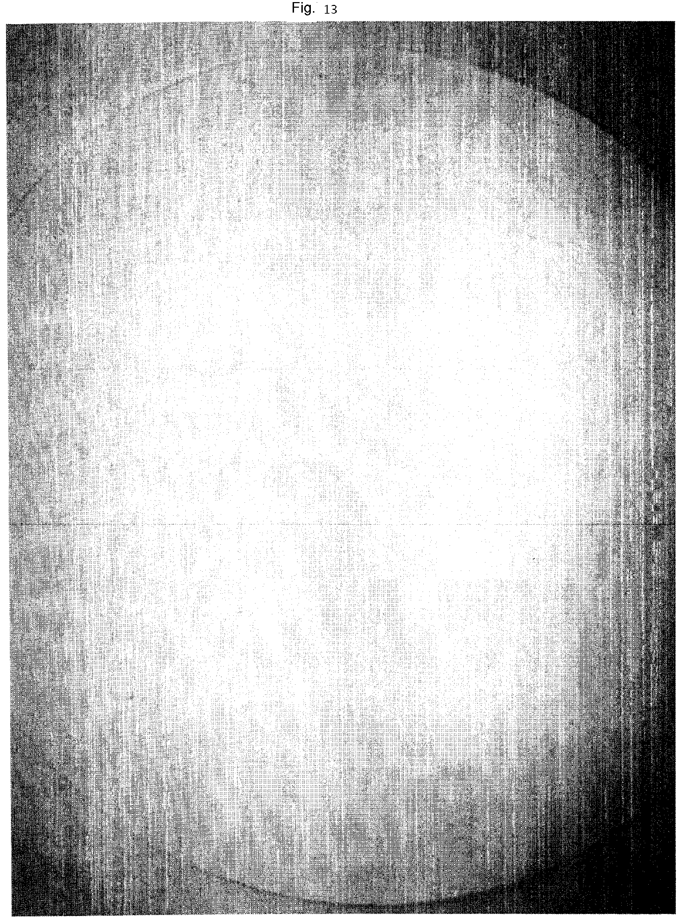

These results will show that, though a PBN coat has been recognized to be opaque, by controlling the thickness of the PBN overcoat 23 to 700 *µ*m or less, it is possible to provide transparency sufficient for reading the product serial number marked on the body surface, which proves that this is a suitable way for indication of traceability. When the thickness of the PBN overcoat 23 was 900 *µ*m, the product serial number was barely visible but the visibility was decreased such that the digits were not distinguishable. Accordingly, the upper limit of the thickness of the PBN overcoat should be determined to be 700 *µ*m. A more preferable upper limit is 500 *µ*m. Incidentally, in Fig.13 that is a photograph showing the visibility of the product serial number in the case of the thickness of the PBN overcoat 23 being 700 *µ*m, the visibility of the product serial number might seem to be not always sufficient, but the product serial number was in fact sufficiently clear by visual observation.

When the present invention is applied to a PBN-coated product comprising a substrate and a PBN coat formed on its surface, it is preferable to change process order and/or position of the traceability indicator, depending upon the substrate.

More specifically, in a case of a PBN substrate/PBN coat product wherein the surface of the PBN substrate is coated with the PBN coat, this is preferably manufactured in the order of forming the PBN substrate by a CVD method, for example, which is then removed from the mandrel, providing the traceability indicator at any place on its surface, and forming the PBN coat again by the CVD method, for example. In other words, the traceability indicator should preferably be formed during the manufacturing of the PBN-coated product. In this case, the PBN coat per se of the product will also function as the PBN overcoat 23 according to the present invention, which has the same construction as shown in Fig.9 and Fig.10.

On the contrary, in a case of a PBN-coated product using a substrate of graphite (including PG), even if a traceability indicator made of graphite is marked on the surface of the graphite substrate, it cannot be visually observed. Accordingly, it is necessary to manufacture a graphite substrate/PBN coat product through a routine procedure, providing a traceability indicator at any place on the surface of the PBN coat, and then forming a PBN overcoat by a CVD method, for example. An example of such product is shown in Fig.29, which is a plate-shaped PBN-overcoated product. This PBN-overcoated product 29 includes a traceability indicator 27 at a bottom of a graphite substrate/PBN coat product comprising a graphite substrate 25, a PBN coat 26 formed on its surface, and a PBN overcoat 28 formed on the entire surface including the surface area with the traceability indicator.

### Legends

- 11: PBN hearth liner body (body)
- 12: product serial number (traceability indicator)
- 13: PG coat
- 14: PG-coated PBN hearth liner (PG-coated product)
- 21: body
- 22: product serial number (traceability indicator)
- 23: PBN overcoat
- 24: PBN-overcoated product
- 25: graphite substrate
- 26: PBN coat
- 27: product serial number (traceability indicator)
- 28: PBN overcoat
- 29: PBN-overcoated product

## Claims

1. A PG-coated product comprising a body and a PG coat formed on a surface thereof, **characterized by** an indication of traceability made of graphite at any place on the body surface, said indication of traceability being visible from the outside through the PG coat having a thickness of 100 *µ*m or less.

2. A method for manufacturing a PG-coated product with a traceability indicator, **characterized by** manufacturing a body, providing a traceability indicator at any place of a surface of the body with graphite, and coating the body surface, including the traceability indicator, with a PG coat having a thickness of 100 *µ*m or less.

3. A PBN-coated product with a traceability indicator, **characterized in that** the traceability indicator made of graphite is provided at any place on a PBN surface of a body, at least of a surface thereof being made of PBN, and a PBN layer overcoats the PBN body surface including the traceability indicator, said PBN overcoat having a thickness of 700 *µ*m or less, said traceability indicator being visible from the outside through the PBN overcoat.

4. A method for displaying traceability to a PBN product, **characterized by** manufacturing a body wherein at least a surface thereof is made of PBN, providing an traceability indicator of graphite at any place of a PBN surface of the body, and overcoating the surface, including the traceability indicator, with a PBN overcoat, said PBN overcoat having a thickness of 700 *µ*m or less so that the traceability indicator is visible from the outside through the PBN overcoat.

## Patentansprüche

1. PG-beschichtetes Produkt, umfassend einen Körper und eine auf einer Oberfläche davon ausgebildete PG-Beschichtung, **gekennzeichnet durch** eine Anzeige einer Rückverfolgbarkeit aus Graphit an einer beliebigen Stelle an der Körperoberfläche, wobei die Anzeige der Rückverfolgbarkeit von außen **durch** die PG-Beschichtung, welche eine Dicke von höchstens 100 µm aufweist, hindurch sichtbar ist.

2. Verfahren zum Herstellen eines PG-beschichteten Produkts mit einer Rückverfolgbarkeitsanzeige, **gekennzeichnet durch** Herstellen eines Körpers, Bereitstellen einer Rückverfolgbarkeitsanzeige mit Graphit an einer beliebigen Stelle einer Oberfläche des Körpers und Beschichten der Körperoberfläche, einschließlich der Rückverfolgbarkeitsanzeige, mit einer PG-Beschichtung mit einer Dicke von höchstens 100 µm.

3. PBN-beschichtetes Produkt mit Rückverfolgbarkeitsanzeige, **dadurch gekennzeichnet, dass** die Rückverfolgbarkeitsanzeige aus Graphit an einer beliebigen Stelle an einer PBN-Oberfläche eines Körpers oder wenigstens einer Oberfläche davon, die aus PBN besteht, bereitgestellt wird, und dass eine PBN-Schicht die PBN-Körperoberfläche einschließlich der Rückverfolgbarkeitsanzeige überzieht, wobei die PBN-Überzugschicht eine Dicke von höchstens 700 µm aufweist, wobei die Rückverfolgbarkeitsanzeige von außen durch die PBN-Überzugschicht hindurch sichtbar ist.

4. Verfahren zum Anzeigen von Rückverfolgbarkeit auf einem PBN-Produkt, **gekennzeichnet durch** Herstellen eines Körpers, wobei wenigstens eine Oberfläche aus PBN gefertigt ist, Bereitstellen einer Rückverfolgbarkeitsanzeige aus Graphit an einer beliebigen Stelle einer PBN-Oberfläche des Körpers und Überziehen der Oberfläche, einschließlich der Rückverfolgbarkeitsanzeige, mit einer PBN-Überzugschicht, wobei die PBN-Überzugschicht eine Dicke von höchstens 700 µm aufweist, sodass die Rückverfolgbarkeitsanzeige von außen **durch** die PBN-Überzugschicht hindurch sichtbar ist.

## Revendications

1. Produit enrobé de PG comprenant un corps et un enrobage de PG formé sur une surface de celui-ci, **caractérisé par** une indication de traçabilité constituée de graphite en tout endroit sur la surface du corps, ladite indication de traçabilité étant visible depuis l'extérieur à travers l'enrobage de PG ayant une épaisseur de 100 µm ou moins.

2. Procédé de fabrication d'un produit enrobé de PG doté d'un indicateur de traçabilité, **caractérisé par** la fabrication d'un corps, la fourniture de graphite à un indicateur de traçabilité en tout endroit d'une surface du corps, et l'enrobage de la surface du corps, incluant l'indicateur de traçabilité, d'un enrobage de PG ayant une épaisseur de 100 µm ou moins.

3. Produit enrobé de PBN doté d'un indicateur de traçabilité, **caractérisé en ce que** l'indicateur de traçabilité constitué de graphite est disposé en tout endroit sur une surface de PBN d'un corps, au moins une surface de celui-ci étant constitué de PBN, et une couche de PBN surenrobe la surface du corps de PBN incluant l'indicateur de traçabilité, ledit surenrobage de PBN ayant une épaisseur de 700 µm ou moins, ledit indicateur de traçabilité étant visible depuis l'extérieur à travers le surenrobage de PBN.

4. Procédé d'affichage de la traçabilité sur un produit de PBN, **caractérisé par** la fabrication d'un corps dont au moins une surface est constituée de PBN, la fourniture d'un indicateur de traçabilité de graphite en tout endroit d'une surface de PBN du corps, et le surenrobage de la surface, incluant l'indicateur de traçabilité, avec un surenrobage de PBN, ledit surenrobage de PBN ayant une épaisseur de 700 µm ou moins de sorte que l'indicateur de traçabilité est visible depuis l'extérieur à travers le surenrobage de PBN.
